# EUROPEAN PATENT SPECIFICATION

(11) **EP 3 664 215 B1**
(45) Date of publication and mention of the grant of the patent: **21.09.2022**
(21) Application number: 18211012.2
(22) Date of filing: 07.12.2018
(51) Int. Cl.: H01P 1/18, H01Q 3/36, H03H 7/18

(54) **RADIO FREQUENCY PHASE SHIFTING DEVICE**
FUNKFREQUENZPHASENVERSCHIEBUNGSVORRICHTUNG
DISPOSITIF DE DÉCALAGE DE PHASE DE FRÉQUENCE RADIO

(43) Date of publication of application: 10.06.2020
(73) Proprietor: ALCAN Systems GmbH, 64293 Darmstadt (DE)
(72) Inventor: Karabey, Onur Hamza, 64289 Darmstadt (DE); Gölden, Felix, 64380 Rossdorf (DE); Gäbler, Alexander, 64287 Darmstadt (DE)
(74) Representative: Habermann Intellectual Property Partnerschaft von Patentanwälten mbB

(56) References cited:
- US-A1- 2002 051 334
- US-A1- 2016 006 092

## Description

### Technical Field

The invention relates to a radio frequency phase shifting device with a transmission line, whereby the transmission line comprises a first electrode and a second electrode that are spaced at a distance to each other, and which are suitable and used for propagation of a radio frequency electromagnetic signal along the first electrode and the second electrode with a phase difference of 180° between the respective electromagnetic signals, wherein a tunable dielectric material affects a phase shift of the electromagnetic signal that is propagated along the transmission line.

### Background of the invention

Phase shifting devices can be used to modify the relative displacement between two corresponding features like peaks or zero crossings of an electromagnetic wave or signal without changing the frequency of the electromagnetic wave or signal. When two or more electromagnetic signals of the same frequency are superimposed, the result depends on the phase difference between the respective electromagnetic signals. The electromagnetic signals can be reinforced or weakened. Furthermore, by superimposing two or more electromagnetic waves that are radiated by respective antennas, the phase difference between the radiated electromagnetic waves will determine a direction of a reinforced superposition of the electromagnetic waves, resulting in a preferred direction of irradiation originating from the respective antennas.

In order to intensify the reception or emission of electromagnetic irradiation from a given direction, a phased array antenna comprises several antenna elements that are distributed next to each other. The phase difference of electromagnetic signals received or emitted by the respective antennas is predetermined in such a manner that the superposition of the respective signals is maximized for a given direction, resulting in enhanced signal sensitivity or signal emission for said direction.

There are known prior art phase shifting devices that create a pre-set phase difference between the incoming and outgoing signal. A phased array antenna that is equipped with such constant phase shifting devices can be designed to maximize the signal sensitivity or signal emission for a given single direction.

US 2002/005334 A1 discloses a voltage tunable varactor and describes a method for modifying the capacity of a capacitor by varying a voltage that is applied to the varactor.

Furthermore, phase shifting devices with a tunable phase difference are known and described e.g. in EP 2 761 693 A1 or EP 2 956 986 B1 or in US 2016/0006092 A1. These phase shifting devices include a linear transmission line comprising a first electrode and a second electrode that are spaced at a distance to each other, wherein a tunable dielectric material is arranged between the first electrode and the second electrode. The phase difference created by a tunable phase shifting device can be tuned, i.e. it can be operated to produce different phase differences whereby the respective phase difference can be modified and controlled by a control setting applied to the tunable dielectric material which affects the phase of the signal along the linear transmission line. A phased array antenna with several antennas that are interconnected with such tunable phase shifting devices can be operated in such a manner as to change the direction of enhanced signal sensitivity or signal emission in accordance to the requirements at a given time.

However, it has been found that the performance of some phase shifting devices is affected by inherent radiation in an undesired manner. In order to reduce the unwanted radiation of electromagnetic waves within the phase shifting device additional features are required that increase the manufacturing costs and the space requirements for such a phase shifting device.

Accordingly, there is a need for a phase shifting device that allows for easy manufacturing, provides for a large phase difference between the input signal and the output signal and allows for a good performance with reduced emission of electromagnetic waves along the transmission line.

### Summary of the invention

The present invention relates to a radio frequency phase shifting device with a transmission line with a first electrode and a second electrode, characterized in that each of the first electrode and the second electrode is divided into several upper segments and lower segments that are spaced apart in a first direction perpendicular to the direction of signal transmission along the transmission line and that are serially arranged along the transmission line, whereby adjacent lower segments and upper segments comprise serially overlapping areas that are filled with the tunable dielectric material, thereby each forming a tunable series capacitor, and further characterized in that the first electrode and the second electrode are spaced apart in a second direction perpendicular to the first direction, whereby the transmission line comprises parallel overlapping sections, wherein an overlapping area of the first electrode is overlapped by a capacitor electrode area and wherein an overlapping area of the second electrode is overlapped by a capacitor electrode area, and whereby the tunable dielectric material is arranged between the respective capacitor electrode areas and the overlapping area of the first electrode and the overlapping area of the second electrode in order to provide for a tunable parallel capacitor within the parallel overlapping section of the transmission line that affects the phase of the radio frequency electromagnetic signal that propagates along the parallel overlapping section of the transmission line.

The phase of the electromagnetic signal that propagates along the transmission line will be affected by the serially overlapping areas that provide for tunable series capacitors as well as by the parallel overlapping sections that provide for tunable parallel capacitors. Both, the tunable series capacitors and the tunable parallel capacitors are distributed along the transmission line. For most applications a regular sequence of a tunable series capacitor followed by a tunable parallel capacitor allows for a good performance of the phase shifting device. However, it is also possible to arrange for a non-regular sequence of tunable series capacitors and tunable parallel capacitors. It is also possible to provide for a number of consecutive tunable series capacitors, that are followed by one or more tunable parallel capacitors. Furthermore, the distance between successive tunable series or parallel capacitors may be constant or varying along the transmission line. Also, the size or shape of the overlapping areas of the tunable series capacitors and of the tunable parallel capacitors may be identical or varying along the transmission line. A phase shifting device may comprise an arbitrary number and order of tunable series capacitors and tunable parallel capacitors. The electromagnetic signal is preferably a radiofrequency signal with a frequency in the range of 20 kHz to 300 GHz. The phase shifting device is adapted to transmit such a radiofrequency signal and to affect and modify the phase of this signal.

The resulting phase shift created along the transmission line depends inter alia on the number and the area of the serially overlapping areas of the tunable series capacitors as well as on the number and the area of the capacitor electrode areas of the tunable parallel capacitors that are implemented along the transmission line.

Preferably the tunable dielectric material is a liquid crystal material with a high dependency of the dielectric characteristics on an electric field that is applied to the liquid crystal material. Suitable liquid crystal materials as well as other tunable dielectric materials are known in the art and commercially available. The electric field that is applied to the liquid crystal material superimposes the radio frequency signal that is propagated along the transmission line, but this does not significantly interfere with the signal propagation.

According to an advantageous aspect of the invention the overlapping area of the first electrode overlaps the overlapping area of the second electrode in order to provide for one parallel plate capacitor area for each of the tunable parallel capacitor within the parallel overlapping section of the transmission line. Thus, no dedicated and separate capacitor electrodes are required for the tunable parallel capacitors. The first electrode and the second electrode are divided into sections that do not overlap each other and into sections that overlap each other. The tunable dielectric material is arranged between the first electrode and the second electrode. The tunable dielectric material may be arranged as a layer that is confined by glass or other material. The surface of the layer may extend over both electrodes and cover overlapping sections and non-overlapping sections of the first electrode and the second electrode. It is also possible to limit the tunable electric material to separate areas that only cover the respective capacitor electrode areas between the first electrode and the second electrode.

According to an alternative aspect of the invention the first electrode and the second electrode are arranged side by side in the second direction and wherein the respective upper segments and lower segments of the first electrode and the second electrode within an parallel overlapping section are arranged at the same level in the first direction, and wherein a capacitor electrode is arranged in the first direction above or below the corresponding upper segments or lower segments of the first electrode and the second electrode in such a manner that a first capacitor electrode area overlaps the overlapping area of the first electrode and that a second capacitor electrode area overlaps the overlapping area of the second electrode, thus providing for two parallel plate capacitor areas between the capacitor electrode and the respective overlapping areas within the parallel overlapping section. Corresponding lower segments as well as upper segments of the first electrode and the second electrode may be arranged next to another on the same level along the first direction. In addition to these lower and upper segments of the first electrode and of the second electrode at least one or a few, but preferably as many capacitor electrodes as lower segments and upper segments are arranged at another level below or above each of the lower or upper segments of the first and second electrodes. The use of separate capacitor electrodes allows for complex shapes of the parallel plate capacitor areas of the tunable parallel capacitors within the parallel overlapping sections along the transmission line and may simplify the manufacturing of the phase shift device. Furthermore, the capacitor electrodes provide for two overlapping areas within each of the parallel overlapping sections which allows for more options for designing and better performance of the parallel overlapping sections.

According to an advantageous embodiment of the invention, all upper segments of the first electrode and of the second electrode are arranged at an upper level and all lower segments of the first electrode and of the second electrode are arranged at a lower level that is spaced apart from the upper level along the first direction. Furthermore, according to another aspect of the invention all upper segments of the first electrode and of the second electrode are arranged at a first surface of a first substrate layer, and in that all lower segments of the first electrode and of the second electrode are arranged at a second surface of a second substrate layer, whereby the first surface of the first substrate layer faces the second surface of the second substrate layer. The first electrode and the second electrode can be manufactured by deposition of electroconductive material for the lower segments and for the upper segments onto a corresponding non-conducting substrate layer. The two substrate layers can be spaced at a distance to each other, thereby confining an intermediary layer of the tunable dielectric material. Such a sandwich structure can be manufactured by easily controllable and reliable methods. The space requirement is approximately one millimeter for the thickness of the sandwich structure. Manufacture of the sandwich structure is similar to fabrication of liquid crystal displays and can be integrated into the respective production methods which then include such phase shifting devices. The substrate layers can be made of glass or any other material with nonconductive or sufficiently low conductive characteristics and with sufficient surface smoothness.

According to an advantageous embodiment of the invention the first surface of the first substrate layer and the second surface of the second substrate layer confine the tunable dielectric material.

The lower segments and the upper segments of the first electrode can be arranged along a linear path of a strip-shaped first electrode. Also, the lower segments and the upper segments of the second electrode can be arranged along a linear path of a strip-shaped second electrode that is parallel to the first electrode. The strip-shaped first and second electrodes usually are of uniform width along the transmission line.

The strip-shaped first electrode and second electrode can also be curved. It is also possible for the strip-shaped first and second electrode to comprise linear sections in combination with corners or curved sections. Furthermore, the strip-shaped first and second electrodes may also have a spiral shape or meandering shape. The strip-shape first and second electrodes may also have a zig-zag pattern.

According to another aspect of the invention, within a parallel overlapping section along the transmission line either an upper segment of the first electrode is paired with a lower segment of the second electrode, or that a lower segment of the first electrode is paired with an upper segment of the second electrode. Then the overlapping area of the first electrode may overlap the overlapping area of the second electrode to provide for the tunable parallel capacitor within the parallel overlapping section of the transmission line. Each of the overlapping areas of the first electrode and/or of the second electrode is laterally protruding from the respective strip-shaped lower or upper segment of the first electrode and/or of the second electrode. When viewed from above, the combined shape of the lower and upper segments of the first electrode and of the lower and upper segments of the second electrode can be similar to a ladder, wherein the strip-shaped parts of the lower and upper segments of the first electrode and of the second electrode are similar to the first and second ladder beams, and wherein the laterally protruding overlapping areas are similar to the rungs of the ladder. Each rung of the ladder comprises one overlapping area that protrudes from the strip-shaped lower and upper segments of the first electrode, and one overlapping area that protrudes from the strip-shaped lower and upper segments of the second electrode. Even though the two respective overlapping areas of the first and second electrode do overlap in the second direction, they are spaced apart and separated by the tunable dielectric material that is between the first electrode and the second electrode in the first direction, or at least between the overlapping areas of the first electrode and the second electrode.

In yet another embodiment of the invention the respective overlapping areas of the first electrode and the second electrode within a tunable series capacitor or within a tunable parallel capacitor provide for a rectangular or a quadratic parallel plate capacitor area. However, the overlapping areas within a tunable series capacitor or within a tunable parallel capacitor may have any shape and contour that is advantageous for the desired phase shift or for the design of the electronic component that includes the phase shifting device.

In yet another aspect of the invention, subsequent tunable parallel capacitors along the transmission line differ in respective distance to each other and/or in size and/or in shape. Also, subsequent tunable series capacitors may differ in respective distance to each other and/or in size and/or in shape. Thus, the tunable series capacitors and the tunable parallel capacitors may be of identical shape and size and may be arranged in a regular pattern along the transmission line. However, it might be advantageous e.g. for signal propagation or for reduced size or manufacturing costs to arrange for tunable series capacitors and/or tunable parallel capacitors that have a different shape or size along the transmission line. Also, the distance between two adjacent tunable series capacitors and tunable parallel capacitors may vary according to demands related to size or cost of the phase shifting device, or in order to allow for better signal propagation or enhanced phase shifting properties of the phase shifting device.

According to another aspect of the invention, the first or the second electrode or both electrodes can be referenced to one or more ground electrodes. The ground electrodes are spaced at a distance to the corresponding first or second electrode. Preferably, the ground electrodes are located on the outward facing surfaces of the substrate layers. The ground electrodes provide for a shielding with respect to the signal propagation along the first and second electrodes. The electrically conductive ground electrodes define boundary surfaces for electromagnetic waves and thus result in a compression of the spatial distribution of electromagnetic fields during signal propagation. By adding ground electrodes, the characteristics of signal propagation along the first and second electrodes and thus along the transmission line can be modified.

However, the phase shifting device does not rely on the presence of a ground electrode. If e.g. for reasons of integrating the sandwich structure with other layers of a phased array antenna one or more ground electrodes are necessary, the size and the distance of the lower and upper segments of the first and second electrode can be easily adjusted when compared to a phase shifting device without ground electrodes.

According to an aspect of the invention, the upper segments and the lower segments of the first electrode and of the second electrode are electrically connected to first and second bias electrodes of at least one bias voltage source. The bias voltage can be a constant bias voltage or a preferably low frequency voltage with a frequency of up to several kHz. The bias voltage does not interfere with the signal propagation along the transmission line of the phase shifting device. The bias voltage that is applied to the first and second electrode by the bias voltage source affects the dielectric characteristics of the tunable dielectric material that is arranged between the first and the second electrode. By applying a bias voltage to the first and second electrode, i.e. to the upper segments and the lower segments of the first electrode and of the second electrode, and thereby affecting and changing the dielectric properties of the tunable dielectric material in between the serially overlapping areas of the tunable series capacitor, the phase difference between the input signal and the output signal of the phase shifting device can be easily and reliably controlled and modified according to the respective requirements.

Furthermore, it is also possible to apply a first bias voltage to the tunable series capacitors and a second bias voltage to the tunable parallel capacitors that are formed in the parallel overlapping sections of the transmission line between the first electrode and the second electrode. This increases the possibilities for controlling and modifying the phase shift created by the phase shifting device.

According to an advantageous embodiment of the invention, all lower segments of the first electrode and of the second electrode are connected to a first bias electrode which is connected to the bias voltage source, and that all upper segments of the first electrode and of the second electrode are connected to a second bias electrode which is connected to the bias voltage source.

In an alternative embodiment all capacitor electrodes overlapping lower segments of the first and second electrode are arranged at the same first capacitor level along the first direction, whereby all capacitor electrodes at the first capacitor level are connected with a first capacitor electrode bias line, and in that all capacitor electrodes overlapping upper segments of the first and second electrode are arranged at the same second capacitor level along the first direction, whereby all capacitor electrodes at the second capacitor level are connected with a second capacitor electrode bias line. Such an embodiment is easily manufactured and allows for directly contacting all capacitor electrodes with the respective first and second bias electrode.

The width of the bias electrodes can be small when compared to the width of the first electrode and of the upper segments and of the lower segments of the first and second electrode. The width can be approx. 10 % or less of the width of the first or second electrode. A small width or cross-section area of the first and second bias electrodes contributes to a high impedance of the first and second bias electrode resulting in reduced leakage of the electromagnetic signal from the first and second electrode into the first or second bias electrode.

In yet another embodiment of the invention the first and second bias electrodes consists of a material with a lower electrical conductivity than the first and second electrode. The resulting higher resistance of the bias electrodes prevents the electromagnetic signal that propagates along the transmission line from leaking from the first and second electrode into the first or second bias electrode. Preferably the first and second electrode are made of or comprise a material with a high conductivity of more than 40 * 10⁶ S/m like e.g. gold or copper. The first and second bias electrode preferably have a sheet resistance of more than 20 Ohms/square and can be made of or comprise Indium Tin Oxide (ITO) or Nichrome (NiCr).

According to another aspect of the invention, the width of the first and second electrode is between 50 µm and 500 µm, preferably approx. 200 µm. Furthermore, the width of the overlapping area between the first electrode and the second electrode is between 50 µm and 500 pm, preferably approx. 200 µm. The width of the first and second electrode should be smaller than Lambda/10, i.e. one-tenth of the characteristic wavelength of the electromagnetic signal that propagates along the transmission line. The lateral distance between the first electrode and the second electrode can be less than 50 µm or even less than 25 µm. For most applications the distance is between 10 µm and 200 µm. However, it is also possible to provide for a distance of more than 200 µm. In general, it is considered advantageous for the distance to be smaller than Lambda/10.

The invention also relates to a phased array antenna comprising several antenna elements, a signal feed network from or to which a signal is transmitted to or from the several antenna elements, and for each antenna element a corresponding phase shifting device as described above, whereby the phase of each signal that is transmitted from the signal feed network to the respective antenna element or that is transmitted from the respective antenna element to the signal feed network is modified in order to adjust the superposition of each signal according to the preferred direction of radiation of the antenna system.

In order to facilitate the manufacturing, the phased array antenna comprises on top of each other a first substrate layer with lower segments of the first and second electrode, a tunable layer that comprises the tunable dielectric material, a second substrate layer with upper segments of the first and second electrode, and an antenna layer with a radiating antenna structure. The lower and upper segments can be arranged onto the respective surface of the first and second substrate layer by any suitable method, e.g. by printing or vapor deposition or by any method used within the semiconductor industry. The lateral dimension of the phased array antenna can be some millimeters or up to some centimeters or decimeters. The dimensions are preferably adapted to the frequency of the electromagnetic signal that is received or emitted by the respective antennas. The more antenna elements that are incorporated into the phased array antenna, the larger the lateral dimensions will be. The individual antenna elements are preferably arranged in a regular grid pattern of a rectangular or quadratic shape. However, it is also possible to arrange the antenna elements of the phased array antenna in a circular shape with several concentric circles of individual antenna elements.

According to an advantageous embodiment of the invention, the first substrate layer and the second substrate layer consists of a glass material, and the tunable layer comprises a liquid crystal material with tunable dielectric properties.

### Brief description of the drawings

The present invention will be more fully understood, and further features will become apparent, when reference is made to the following detailed description and the accompanying drawings. The drawings are merely representative and are not intended to limit the scope of the claims. In fact, those of ordinary skill in the art may appreciate upon reading the following specification and viewing the present drawings that various modifications and variations can be made thereto without deviating from the innovative concepts of the invention as defined by the appended claims. Like parts depicted in the drawings are referred to by the same reference numerals.
Figure 1 illustrates a schematic top view of a section of a transmission line of a phase shifting device,
Figure 2 illustrates a perspective view of the section of the transmission line as shown in figure 1,
Figure 3 illustrates a sectional view of the transmission line as shown in figure 2 taken along the line III-III,
Figure 4 illustrates a sectional view of the transmission line as shown in figure 2 taken along the line IV-IV,
Figure 5 illustrates a sectional view of the transmission line as shown in figure 2 taken along the line V-V,
Figure 6 illustrates a schematic representation of the transmission line as shown in figures 1 to 5,
Figure 7 illustrates a schematic top view of a transmission line of another embodiment of a phase shifting device,
Figure 8 illustrates a perspective view of the transmission line of the phase shifting device as shown in figure 7,
Figure 9 illustrates a sectional view of the transmission line as shown in figure 8 taken along the line IX-IX,
Figure 10 illustrates a schematic top view of a small part of a transmission line with a first electrode and another embodiment of a first bias electrode,
Figure 11 illustrates a sectional view of another embodiment of a transmission line with varying distance and shape of the overlapping areas along the transmission line,
Figure 12 illustrates a schematic top view similar to Figure 1 of a section of another embodiment of the transmission line of a phase shifting device, and
Figure 13 illustrates yet another schematic top view similar to Figures 1 and 12 of yet another embodiment of the transmission line of a phase shifting device.

### Detailed description of the invention

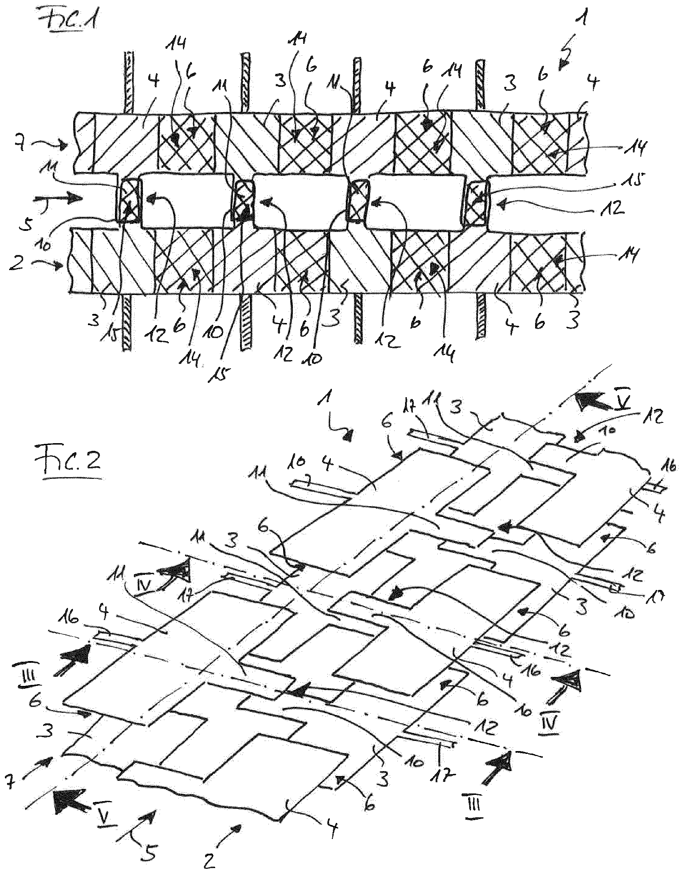

Figures 1 to 5 show a section of a transmission line 1 of a phase shifting device according to the invention as described above. A first electrode 2 comprises lower segments 3 and upper segments 4 of approximately rectangular shape that are arranged along a straight line in the direction 5 of the signal propagation along the transmission line 1. All upper segments 4 are at an upper level and all lower segments 3 are at a lower level that is spaced at a distance to the upper level in a first direction perpendicular to the direction 5 of the signal propagation that equals the direction of the transmission line 1. In the graphical representation of figure 1 all upper segments 4 are hatched in one direction, whereas all lower segments 3 are hatched in a second direction perpendicular to the first hatching direction.

The lower segments 3 and the upper segments 4 of the first electrode 2 are serially arranged along the transmission line 1, i.e. each lower segment 3 is followed by an upper segment 4 and each upper segment 4 is followed by a lower segment 3. Adjacent lower segments 3 and upper segments 4 as well as adjacent upper segments 4 and lower segments 3 comprise serially overlapping areas 6 wherein a part of the lower segment 3 overlaps with a part of the adjacent upper segment 4, and an opposite part of this upper segment 4 overlaps with a part of the subsequent lower segment 3.

The transmission line 1 also comprises a second electrode 7 that also comprises lower segments 3 and upper segments 4 that are arranged in an identical manner as the corresponding lower and upper segments 3, 4 of the first electrode 2. However, the first electrode 2 and the second electrode 7 are spaced at a distance in a second direction that is perpendicular to the direction 5 of the transmission line 1 as well as perpendicular to the first direction with lower and upper levels for the lower and upper segments 3,4, of the first and second electrode 2, 7. The lower segments 3 and the upper segments 4 of the first and second electrode 2, 7 comprise overlapping areas 10, 11 that project towards the corresponding upper or lower segment 4, 3 in a manner to provide for a parallel overlapping area 12 of adjacent lower and upper segments 3, 4 of the first and second electrode 2, 7. These parallel overlapping areas 12 provide for parallel plate capacitor electrodes between the first and second electrode 2, 7.

Between the lower segments 3 and the upper segments 4 there is a tunable dielectric material 13. The tunable dielectric material 13 is a liquid crystal material with molecules whose alignment depend on a bias voltage that is applied to the lower segments 3 and the upper segments 4 that form the parallel plate capacitor electrodes within the serially overlapping areas 6 of the lower segments 3 and the upper segments 4. Thus, the properties of a tunable series capacitor 14 that is formed between adjacent parts of the lower segments 3 and the upper segments 4 within the serially overlapping areas 6 is affected by the bias voltage that is applied to the lower segments 3 and to the upper segments 4 of the first electrode 2 and the second electrode 7. Similarly, there is also a tunable dielectric material 13 arranged between the parallel overlapping areas 12 of adjacent lower and upper segments 3, 4 of the first and second electrode 2, 7, thereby forming a tunable parallel capacitor 15 within the parallel overlapping sections of the transmission line 1.

All upper segments 4 are connected to a bias voltage source by first bias electrodes 16. Also, all lower segments 3 are connected to the bias voltage source by second bias electrodes 17. The bias voltage source which is not shown in the figures provides for a constant, i.e. DC voltage or for a low-frequency AC voltage that is applied to the first and second electrode 2, 7 and that creates an electric field in the space between the serially overlapping areas 6 of the first electrode 2 and the second electrode 7, thereby superimposing the electromagnetic field of the signal that propagates along the transmission line 1. The electric field is predominantly perpendicular to the plane of view in figure 1. Due to the material and the small width of the first and second bias electrode 16, 17, the impedance of the first and second bias electrode 16, 17 is significantly higher than the impedance of the lower segments 3 and the upper segments 4 of the first and second electrode 2, 7 which prevents the propagating electromagnetic signal from leaking from the first and second electrode 2, 7 into the first and second bias electrode 16, 17 and away from the transmission line 1. By choosing a highly resistive bias electrode material the impedance of the bias electrodes can be further increased.

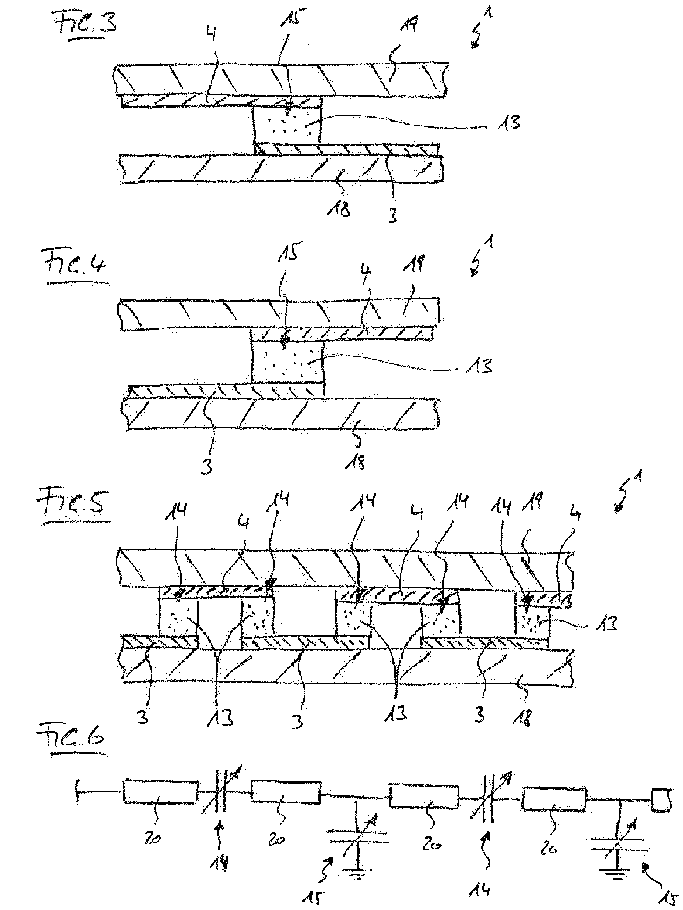

In the figures 3 to 5 there are shown sectional views of an embodiment of the transmission line 1 that is shown in the figures 1 and 2. The lower segments 3 of the first and second electrode 2, 7 are on top of a first substrate layer 18 made of glass material. The upper segments 4 of the first and second electrode 2, 7 are on top of a second substrate layer 19 that is also made of glass material and can be identical to the first substrate layer 18. The first and second substrate layers 18, 19 are arranged at a distance to each other with the upper segments 4 facing towards the lower segments 3. The tunable dielectric material 13, namely a tunable liquid crystal material is arranged in a layer between the first and second substrate layer 18, 19. The tunable dielectric material 13 can be divided into small sections with dimensions that correspond to the serially overlapping areas 6 of the lower segments 3 and the upper segments 4 as well as to the parallel overlapping areas 12 of the lower segments 3 and the upper segments 4. It is also possible to completely fill the layer between the first and second substrate layer 18, 19 with the tunable dielectric material 13.

In figure 6 a schematic representation of the transmission line 1 is shown. The transmission line 1 is divided into several transmission sections 20 of electrode material that are arranged and directed along the signal propagation path. Consecutive transmission sections 16 are separated by tunable capacitors that either form tunable series capacitors 14 or tunable parallel capacitors 15. Thus, the transmission line 1 is similar to a shunt loaded line topology with additional tunable series capacitors 14. The combination of tunable series capacitors 14 and tunable parallel capacitors 15 result in improved phase shifting behavior without significant dependence on the frequency of the signal that propagates along the transmission line 1.

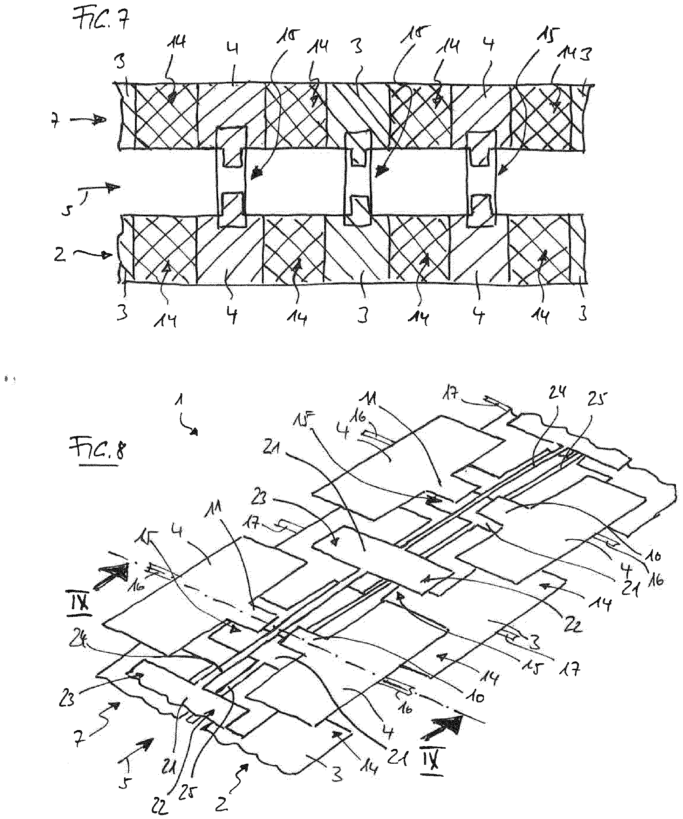

In figures 7 to 9 an alternative embodiment of the transmission line 1 is shown. Contrary to the embodiment of figures 1 to 5, the lower segments 3 of the first electrode 2 are placed next to the lower segments 3 of the second electrode 7. Similarly, the upper segments 4 of the first electrode 2 are placed next to the upper segments 4 of the second electrode 7. In order to provide for the tunable parallel capacitors 15 between either lower segments 3 or upper segments 4 that are at the same lower or upper level, capacitor electrodes 21 are arranged above or below the corresponding protrusions of the overlapping areas 10, 11 that project towards the corresponding adjacent lower or upper segment 3, 4. Each strip-shaped capacitor electrode 21 has two capacitor areas 22, 23 at the respective ends that overlap with the corresponding overlapping areas 10, 11 of the adjacent lower or upper segments 3, 4. The capacitor electrode 21 and the overlapping areas 10, 11 form two connected sections of the tunable parallel capacitor 15 within the respective parallel overlapping section along the transmission line 1.

All capacitor electrodes 21 on the upper level can be connected to a line-shaped bias electrode 24 on the upper level that runs between the first and second electrode 2, 7 along the transmission line 1. Similarly, all capacitor electrodes on the lower level are connected to a line-shaped bias electrode 25 on the lower level. Furthermore, as already described with respect to Figure 2, bias electrodes 16 are connected to upper segments 4 and bias electrodes 17 are connected to lower segments 3 along the transmission line 1.

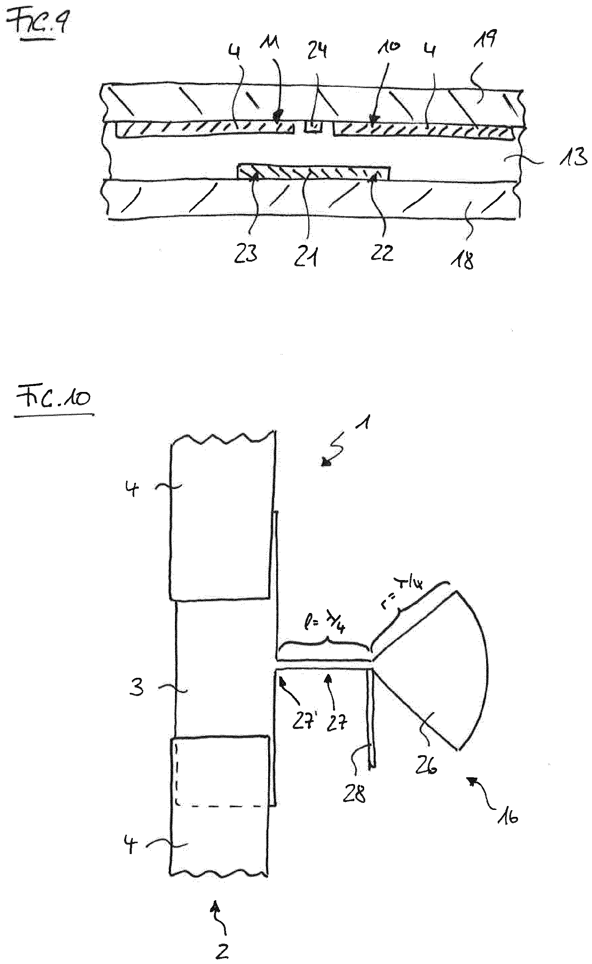

Figure 10 shows another embodiment of the fist bias electrode 16, whereby this embodiment can be also used for second bias electrodes 17. The bias electrode 16 comprises a fan shaped segment 26 that is connected via a connection line segment 27 with the corresponding lower segment 3 of the first electrode 2 via a connection point 27'. Both, the connection point 27' and the connection line segment have a small diameter compared to the dimensions of the lower segment 3 and, more important, compared to the characteristic wave length of the signal propagation along the transmission line 1, i.e. the diameter of the connection point 27 is less than 0.2 and preferably less than 0.1 of λ/4 with A the characteristic wave length of the propagating signal. The length 1 of the connection line segment equals approx. λ/4. Furthermore, also the radius r of the fan shaped segment 26 equals approx. λ/4. On the opposite site of the connection point 27' and close to the fan shaped segment 26 a line shaped bias line segment 28 extends from the connection line segment 27 and provides for the connection with the bias voltage source. Such an embodiment of the bias electrodes 16, 17 provides for a filter or choke that prevents undesired energy dissipation of radio frequency electromagnetic waves away from the transmission line 1 into the bias electrodes 16, 17.

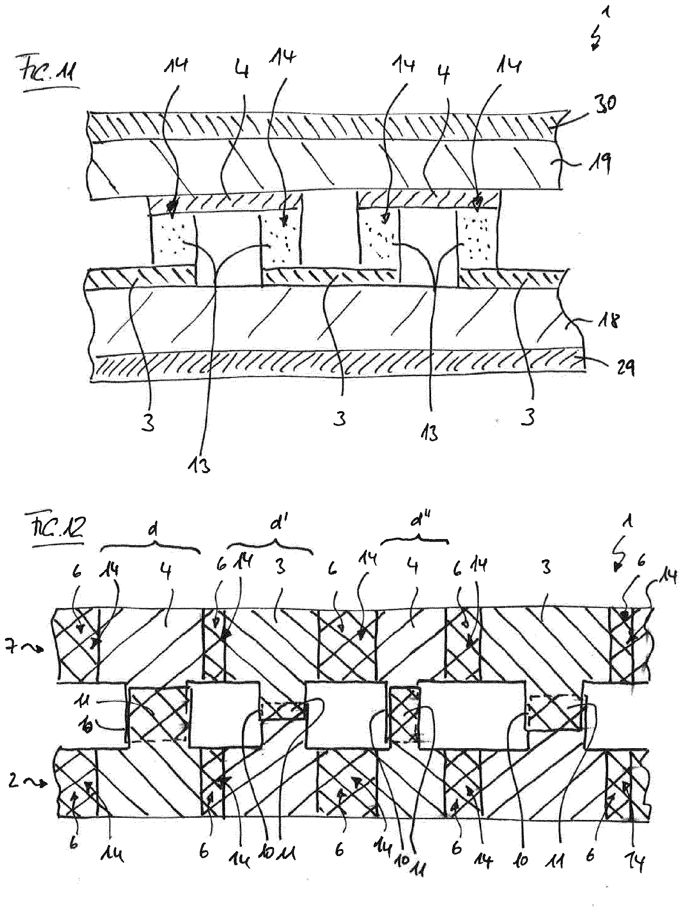

Figure 11 shows a sectional view of a transmission line 1 as shown in figure 5. However, according to another embodiment of the transmission line 1 there is a first ground electrode 29 arranged at the outside surface of the first substrate layer 18 as well as a second ground electrode 30 arranged at the outside surface of the second substrate layer 19. The ground electrodes 29, 30 confine the electromagnetic waves into the space between the two ground electrodes 29, 30 and thus result in a modification of the characteristic features of the signal propagation along the transmission line 1.

In figure 12 a schematic top view of another exemplary embodiment of the transmission line 1 is shown. This embodiment differs from the embodiment shown in figure 1 due to the irregular arrangement and shape of the overlapping areas 6, 10, 11 of the tunable serial capacitors 14 as well as of the tunable parallel capacitors 15. As can be seen from the exemplary embodiment of figure 12, the distances d, d' and d" between adjacent tunable serial capacitors 14 may vary. Furthermore, the shape and area of each overlapping area 6 of the tunable serial capacitors 14 may vary as well. Also, the shape and area of the overlapping areas 10, 11 of the tunable parallel capacitors 15 may vary between adjacent tunable parallel capacitors 15, resulting e.g. in a different size of the overlapping areas 10, 11. These variations in distance, shape and area of the tunable serial capacitors 14 and tunable parallel capacitors 15 result in different phase shifting properties of the transmission line 1 and allow for easy adjustment of the properties according to the individual requirements.

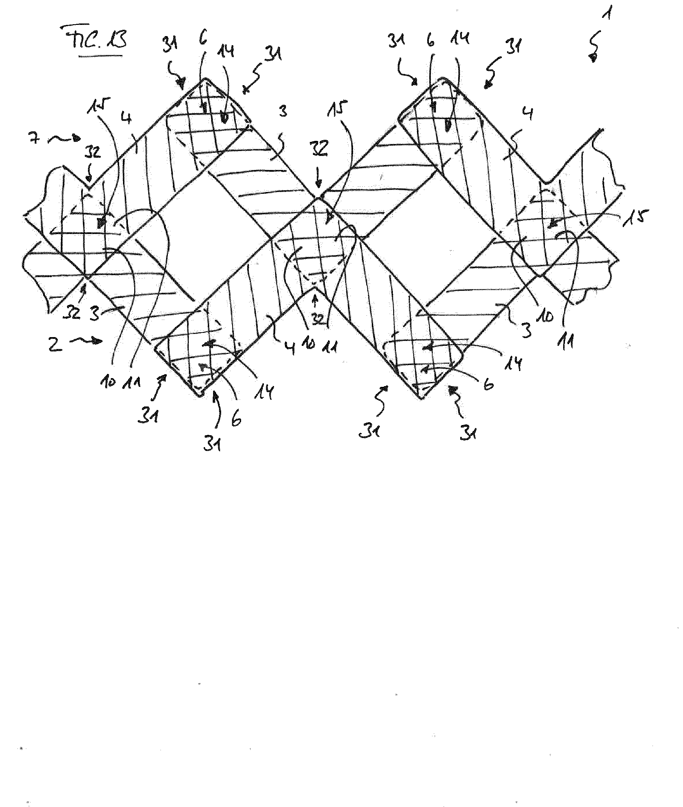

Figure 13 shows a top view similar to figure 12 of yet another exemplary embodiment of the transmission line 1. The lower segments 3 and upper segments 4 of the first and second electrode 2, 7 are L-shaped instead of the straight-line shape of the lower segments 3 and upper segments 4 within the embodiment shown in figures 1 or 12. In figure 13 the lower segments 3 are hatched with horizontal lines, whereas the upper segments 4 are hatched with vertical lines. Due to the arrangement of the L-shaped lower and upper segments 3, 4, the opposing end sections 31 of each lower or upper segment 3, 4 overlap with the corresponding end sections 31 of the adjacent upper or lower segment 4, 3 and form the overlapping areas 6 of the tunable serial capacitors 14 for the respective first or second electrode 2, 7. A corner section 32 in the middle of each lower or upper segment 3, 4 of the first electrode 2 overlaps with a corner section 32 of the corresponding upper or lower segment 4, 3 of the second electrode 7, resulting in the formation of the overlapping areas 10, 11 of the tunable parallel capacitors 15 between the first and second electrode 2, 7.

## Claims

1. Radio frequency phase shifting device with a transmission line (1), whereby the transmission line (1) comprises a first electrode (2) and a second electrode (7) that are spaced at a distance to each other and are configured to propagate a radio frequency electromagnetic signal along the first electrode (2) and the second electrode (7) with a phase difference of 180° between the respective electromagnetic signals, wherein the transmission line further comprises a tunable dielectric material (13) , the tunable dielectric material (13) configured to affect a phase shift of the electromagnetic signal that is propagated along the transmission line (1), wherein each of the first electrode (2) and the second electrode (7) is divided into several upper segments (4) and lower segments (3) that are spaced apart in a first direction perpendicular to the direction of signal transmission along the transmission line (1) and that are serially arranged along the transmission line (1), whereby adjacent lower segments (3) and upper segments (4) comprise serially overlapping areas (6) that are filled with the tunable dielectric material (13), thereby each forming a tunable series capacitor (14), and further the first electrode (2) and the second electrode (7) are spaced apart in a second direction perpendicular to the first direction, whereby the transmission line (1) comprises parallel overlapping sections, wherein an overlapping area (10) of the first electrode (2) is overlapped by a capacitor electrode area (11, 23) and wherein an overlapping area (11) of the second electrode (7) is overlapped by a capacitor electrode area (10, 22), and whereby the tunable dielectric material (13) is arranged between the respective capacitor electrode areas (10, 11, 22, 23) and the overlapping area (10) of the first electrode (2) and the overlapping area (11) of the second electrode (7)in order to provide for a tunable parallel capacitor (15) within the parallel overlapping section of the transmission line (1) that affects the phase of the radio frequency electromagnetic signal that propagates along the parallel overlapping section of the transmission line (1).

2. Radio frequency phase shifting device according to claim 1, wherein the overlapping area (10) of the first electrode (2) overlaps the overlapping area (11) of the second electrode (7) to provide for the tunable parallel capacitor (15) within the parallel overlapping section of the transmission line (1).

3. Radio frequency phase shifting device according to claim 1, wherein the first electrode (2) and the second electrode (7) are arranged side by side in the second direction and wherein the respective upper segments (4) and lower segments (3) of the first electrode (2) and of the second electrode (7) within a parallel overlapping section are
arranged at the same level in the first direction, and wherein a capacitor electrode (21) is arranged in the first direction above or below the corresponding upper segments (4) or lower segments (3) of the first electrode (2) and of the second electrode (7) in such a manner that a first capacitor electrode area (22) overlaps the overlapping area (10) of the first electrode (2) and that a second capacitor electrode area (23) overlaps the overlapping area (11) of the second electrode (7), thus providing for two parallel plate capacitor areas between the capacitor electrode (21) and the respective overlapping areas (10, 11) within the parallel overlapping section.

4. Radio frequency phase shifting device according to one or more of the preceding claims, **characterized in that** all upper segments (4) of the first electrode (2) and of the second electrode (7) are arranged at an upper level and **in that** all lower segments (3) of the first electrode (2) and of the second electrode (7) are arranged at a lower level that is spaced apart from the upper level along the first direction.

5. Radio frequency phase shifting device according to claims 2 and 4, **characterized in that** within a parallel overlapping section along the transmission line (1) either an upper segment (4) of the first electrode (2) is paired with a lower segment (3) of the second electrode (7), or that a lower segment (3) of the first electrode (2) is paired with an upper segment (4) of the second electrode (7) .

6. Radio frequency phase shifting device according to claims 3 and 4, **characterized in that** within a parallel overlapping section along the transmission line (1) either upper segments (4) of the first electrode (2) and of the second electrode (7) are paired, or that lower segments (3) of the first electrode (2) and of the second electrode (7) are paired.

7. Radio frequency phase shifting device according to claim 4, **characterized by** further comprising a first substrate layer (18) and a second substrate layer (19), wherein all upper segments (4) of the first electrode (2) and of the second electrode (7) are arranged at a first surface of the first substrate layer (18), and in that all lower segments (3) of the first electrode (2) and of the second electrode (7) are arranged at a second surface of the second substrate layer (19), whereby the first surface of the first substrate layer (18) faces the second surface of the second substrate layer (19).

8. Radio frequency phase shifting device according to claim 7, **characterized in that** the first surface of the first substrate layer (18) and the second surface of the second substrate layer (19) confine the tunable dielectric material (13).

9. Radio frequency phase shifting device according to one or more of the preceding claims, **characterized by** further comprising first and second bias electrodes (16,17) of at least one bias voltage source, wherein the upper segments (4) and the lower segments (3) of the first electrode (2) and of the second electrode (7) are electrically connected to the first and second bias electrodes (16, 17).

10. Radio frequency phase shifting device according to claim 9, **characterized in that** the width of the first and second bias electrodes (16, 17) is smaller than the width of the first and second electrode (2, 7).

11. Radio frequency phase shifting device according to claim 3, **characterized in that** all capacitor electrodes (21) overlapping lower segments (3) of the first and second electrode (2, 7) are arranged at the same first capacitor level along the first direction, whereby all capacitor electrodes (21) at the first capacitor level are connected with a first capacitor electrode bias line (24), and **in that** all capacitor electrodes (21) overlapping upper segments (4) of the first and second electrode (2, 7) are arranged at the same second capacitor level along the first direction, whereby all capacitor electrodes (21) at the second capacitor level are connected with a second capacitor electrode bias line (25).

12. Radio frequency phase shifting device according to one or more of the preceding claims, **characterized in that** the first or the second electrode (2, 7) or both electrodes (2, 7) are referenced to one or more ground electrodes (29, 30) that are spaced at a distance to the corresponding first or second electrode (2, 7).

13. Radio frequency phase shifting device according to one or more of the preceding claims, **characterized in that** the distance between successive tunable series capacitors (14) or tunable parallel capacitors (15) is constant or varying along the transmission line (1)

14. Radio frequency phase shifting device according to one or more of the preceding claims, **characterized in that** the size or shape of the overlapping areas (6) of the tunable series capacitors (14) and the size or shape of the overlapping areas (10, 11) of the tunable parallel capacitors (15) are identical or varying along the transmission line (1).

15. Phased array antenna comprising several antenna elements, a signal feed network from or to which a signal is transmitted to or from the several antenna elements, and for each antenna element a corresponding phase shifting device according to claim 1, whereby the phase of each signal that is transmitted from the signal feed network to the respective antenna element or that is transmitted from the respective antenna element to the signal feed network is modified in order to adjust the superposition of each signal according to the preferred direction of radiation of the antenna system.

16. Phased array antenna according to claim 15, **characterized in that** the phased array antenna comprises on top of each other a first substrate layer (18), a tunable layer that comprises a tunable dielectric material, a second substrate layer (19) and an antenna layer with a radiating antenna structure for each of the antenna elements.

17. Phased array antenna according to claim 15 or 16, **characterized in that** the first substrate layer (18) and the second substrate layer (19) consists of a glass material, and that the tunable layer comprises a liquid crystal material (13) with tunable dielectric properties.

## Patentansprüche

1. Funkfrequenzphasenverschiebungsvorrichtung mit einer Übertragungsleitung (1), wodurch die Übertragungsleitung (1) eine erste Elektrode (2) und eine zweite Elektrode (7) aufweist, die in einem Abstand voneinander beabstandet sind und konfiguriert sind, um ein elektromagnetisches Hochfrequenzsignal entlang der ersten Elektrode (2) und der zweiten Elektrode (7) mit einer Phasendifferenz von 180° zwischen den jeweiligen elektromagnetischen Signalen zu verbreiten, wobei die Übertragungsleitung weiterhin ein abstimmbares dielektrisches Material (13) aufweist, wobei das abstimmbare dielektrische Material (13) konfiguriert ist, um eine Phasenverschiebung des elektromagnetischen Signals, das sich entlang der Übertragungsleitung (1) ausbreitet, zu beeinflussen, wobei die erste Elektrode (2) und die zweite Elektrode (7) jeweils in mehrere obere Segmente (4) und untere Segmente (3) unterteilt sind, die in einer ersten Richtung, die senkrecht zu der Richtung der Signalübertragung entlang der Übertragungsleitung (1) ist, beabstandet sind und nacheinander entlang der Übertragungsleitung (1) angeordnet sind, wobei aneinander angrenzende untere Segmente (3) und obere Segmente (4) aufeinanderfolgende überlappende Bereiche (6) aufweisen, die mit dem abstimmbaren dielektrischen Material (13) gefüllt sind, wodurch jeweils ein abstimmbarer Reihenkondensator(14) gebildet wird, und ferner die erste Elektrode (2) und die zweite Elektrode (7) in einer zweiten Richtung, die zu der ersten Richtung senkrecht ist, beabstandet sind, wobei die Übertragungsleitung (1) parallele überlappende Abschnitte aufweist, wobei ein überlappender Bereich (10) der ersten Elektrode (2) von einem Kondensatorelektrodenbereich (11, 23) überlappt wird und wobei ein überlappender Bereich (11) der zweiten Elektrode (7) von einem Kondensatorelektrodenbereich (10, 22) überlappt wird und wobei das abstimmbare dielektrische Material (13) zwischen den jeweiligen Kondensatorelektrodenbereichen (10, 11, 22, 23) und dem überlappenden Bereich (10) der ersten Elektrode (2) und dem überlappenden Bereich (11) der zweiten Elektrode (7) angeordnet ist, um einen abstimmbaren Parallelkondensator (15) innerhalb des parallelen überlappenden Abschnitts der Übertragungsleitung (1) bereitzustellen, der die Phase des elektromagnetischen Hochfrequenzsignals, das sich entlang des parallelen überlappenden Abschnitts der Übertragungsleitung (1) ausbreitet, beeinflusst.

2. Funkfrequenzphasenverschiebungsvorrichtung nach Anspruch 1, wobei der überlappende Bereich (10) der ersten Elektrode (2) den überlappenden Bereich (11) der zweiten Elektrode (7) überlappt, um den abstimmbaren Parallelkondensator (15) innerhalb des parallelen überlappenden Abschnitts der Übertragungsleitung (1) bereitzustellen.

3. Funkfrequenzphasenverschiebungsvorrichtung nach Anspruch 1, wobei die erste Elektrode (2) und die zweite Elektrode (7) Seite an Seite in der zweiten Richtung angeordnet sind und wobei die jeweiligen oberen Segmente (4) und unteren Segmente (3) der ersten Elektrode (2) und der zweiten Elektrode (7) innerhalb eines parallelen überlappenden Abschnitts auf der gleichen Ebene in der ersten Richtung angeordnet sind und wobei eine Kondensatorelektrode (21) in der ersten Richtung über oder unter den entsprechenden oberen Segmenten (4) oder unteren Segmenten (3) der ersten Elektrode (2) und der zweiten Elektrode (7) in einer Weise angeordnet ist, dass ein erster Kondensatorelektrodenbereich (22) den überlappenden Bereich (10) der ersten Elektrode (2) überlappt und ein zweiter Kondensatorelektrodenbereich (23) den überlappenden Bereich (11) der zweiten Elektrode (7) überlappt, sodass zwei Parallel-Plattenkondensatorbereiche zwischen der Kondensatorelektrode (21) und den jeweiligen überlappenden Bereichen (10, 11) innerhalb des parallelen überlappenden Abschnitts bereitgestellt werden.

4. Funkfrequenzphasenverschiebungsvorrichtung nach einem oder mehreren der vorstehenden Ansprüche, **dadurch gekennzeichnet, dass** alle oberen Segmente (4) der ersten Elektrode (2) und der zweiten Elektrode (7) in einer oberen Ebene angeordnet sind und alle unteren Segmente (3) der ersten Elektrode (2) und der zweiten Elektrode (7) auf einer unteren Ebene, die von der oberen Ebene entlang der ersten Richtung beabstandet ist, angeordnet sind.

5. Funkfrequenzphasenverschiebungsvorrichtung nach Anspruch 2 und 4, **dadurch gekennzeichnet, dass** innerhalb eines parallelen überlappenden Abschnitts entlang der Übertragungsleitung (1) entweder ein oberes Segment (4) der ersten Elektrode (2) mit einem unteren Segment (3) der zweiten Elektrode (7) gekoppelt ist oder ein unteres Segment (3) der ersten Elektrode (2) mit einem oberen Segment (4) der zweiten Elektrode (7) gekoppelt ist.

6. Funkfrequenzphasenverschiebungsvorrichtung nach den Anspruch 3 und 4, **dadurch gekennzeichnet, dass** innerhalb eines parallelen überlappenden Abschnitts entlang der Übertragungsleitung (1) entweder obere Segmente (4) der ersten Elektrode (2) und der zweiten Elektrode (7) gekoppelt sind oder untere Segmente (3) der ersten Elektrode (2) und der zweiten Elektrode (7) gekoppelt sind.

7. Funkfrequenzphasenverschiebungsvorrichtung nach Anspruch 4, **dadurch gekennzeichnet, dass** sie ferner eine erste Substratschicht (18) und eine zweite Substratschicht (19) aufweist, wobei alle oberen Segmente (4) der ersten Elektrode (2) und der zweiten Elektrode (7) auf einer ersten Oberfläche der ersten Substratschicht (18) angeordnet sind und alle unteren Segmente (3) der ersten Elektrode (2) und der zweiten Elektrode (7) auf einer zweiten Oberfläche der zweiten Substratschicht (19) angeordnet sind,
wobei die erste Oberfläche der ersten Substratschicht (18) der zweiten Oberfläche der zweiten Substratschicht (19) zugewandt ist.

8. Funkfrequenzphasenverschiebungsvorrichtung nach Anspruch 7, **dadurch gekennzeichnet, dass** die erste Oberfläche der ersten Substratschicht (18) und die zweite Oberfläche der zweiten Substratschicht (19) das abstimmbare dielektrische Material (13) begrenzen.

9. Funkfrequenzphasenverschiebungsvorrichtung nach einem oder mehreren der vorstehenden Ansprüche, **dadurch gekennzeichnet, dass** sie ferner erste und zweite Vorspannungselektroden (16, 17) mindestens einer Vorspannungsspannungsquelle aufweist, wobei die oberen Segmente (4) und die unteren Segmente (3) der ersten Elektrode (2) und der zweiten Elektrode (7) mit den ersten und zweiten Vorspannungselektroden (16, 17) elektrisch verbunden sind.

10. Funkfrequenzphasenverschiebungsvorrichtung nach Anspruch 9, **dadurch gekennzeichnet, dass** die Breite der ersten und zweiten Vorspannungselektroden (16, 17) kleiner ist als die Breite der ersten und zweiten Elektrode (2, 7).

11. Funkfrequenzphasenverschiebungsvorrichtung nach Anspruch 3, **dadurch gekennzeichnet, dass** alle Kondensatorelektroden (21), die untere Segmente (3) der ersten und zweiten Elektrode (2, 7) überlappen, auf der gleichen ersten Kondensatorebene entlang der ersten Richtung angeordnet sind, wobei alle Kondensatorelektroden (21) auf der ersten Kondensatorebene mit einer ersten Kondensatorelektroden-Vorspannungsleitung (24) verbunden sind, und dass alle Kondensatorelektroden (21), die obere Segmente (4) der ersten und zweiten Elektrode (2, 7) überlappen, auf der gleichen zweiten Kondensatorebene entlang der ersten Richtung angeordnet sind, wobei alle Kondensatorelektroden (21) auf der zweiten Kondensatorebene mit einer zweiten Kondensatorelektroden-Vorspannungsleitung (25) verbunden sind.

12. Funkfrequenzphasenverschiebungsvorrichtung nach einem oder mehreren der vorstehenden Ansprüche, **dadurch gekennzeichnet, dass** die erste oder die zweite Elektrode (2, 7) oder beide Elektroden (2, 7) zu einer oder mehreren Masseelektroden (29, 30), die in einem Abstand von der entsprechenden ersten oder zweiten Elektrode (2, 7) beabstandet sind, referenziert werden.

13. Funkfrequenzphasenverschiebungsvorrichtung nach einem oder mehreren der vorstehenden Ansprüche, **dadurch gekennzeichnet, dass** der Abstand zwischen aufeinander folgenden abstimmbaren in Reihe geschalteten Kondensatoren (14) oder abstimmbaren parallel geschalteten Kondensatoren (15) konstant ist oder entlang der Übertragungsleitung (1) variiert.

14. Funkfrequenzphasenverschiebungsvorrichtung nach einem oder mehreren der vorstehenden Ansprüche, **dadurch gekennzeichnet, dass** die Größe oder Form der überlappenden Bereiche (6) der abstimmbaren in Reihe geschalteten Kondensatoren (14) und die Größe oder Form der überlappenden Bereiche (10, 11) der abstimmbaren parallel geschalteten Kondensatoren (15) identisch ist oder entlang der Übertragungsleitung (1) variiert.

15. Phasengesteuerte Gruppenantenne, aufweisend mehrere Antennenelemente, ein Signalzuführungsnetz, von dem oder auf das ein Signal von den oder auf die mehreren Antennenelemente übertragen wird, und für jedes Antennenelement eine entsprechende Vorrichtung zur Phasenverschiebung nach Anspruch 1, wobei die Phase jedes Signals, das von dem Signalzuführungsnetz auf das jeweilige Antennenelement übertragen wird oder von dem jeweiligen Antennenelement auf das Signalzuführungsnetz übertragen wird, modifiziert wird, um die Überlagerung jedes Signals gemäß der bevorzugten Abstrahlungsrichtung des Antennensystems einzustellen.

16. Phasengesteuerte Antenne nach Anspruch 15, **dadurch gekennzeichnet, dass** die phasengesteuerte Antenne übereinander eine erste Substratschicht (18), eine abstimmbare Schicht, die ein abstimmbares dielektrischen Material aufweist, eine zweite Substratschicht (19) und eine Antennenschicht mit einer abstrahlenden Antennenstruktur für jedes der Antennenelemente aufweist.

17. Phasengesteuerte Antenne nach Anspruch 15 oder 16, **dadurch gekennzeichnet, dass** die erste Substratschicht (18) und die zweite Substratschicht (19) aus einem Glasmaterial bestehen und die abstimmbare Schicht ein Flüssigkristallmaterial (13) mit abstimmbaren dielektrischen Eigenschaften aufweist.

## Revendications

1. Dispositif de décalage de phase de fréquence radio doté d'une ligne de transmission (1), moyennant quoi la ligne de transmission (1) comprend une première électrode (2) et une seconde électrode (7) qui sont espacées d'une distance l'une de l'autre et sont configurées pour propager un signal électromagnétique de fréquence radio le long de la première électrode (2) et de la seconde électrode (7) avec une différence de phase de 180° entre les signaux électromagnétiques respectifs, dans lequel la ligne de transmission comprend en outre un matériau diélectrique accordable (13), le matériau diélectrique accordable (13) étant configuré pour affecter un décalage de phase du signal électromagnétique qui est propagé le long de la ligne de transmission (1), dans lequel chacune de la première électrode (2) et de la seconde électrode (7) est divisée en plusieurs segments supérieurs (4) et segments inférieurs (3) qui sont espacés dans une première direction perpendiculaire à la direction de transmission de signaux le long de la ligne de transmission (1) et qui sont agencés en séries le long de la ligne de transmission (1), moyennant quoi des segments inférieurs (3) et segments supérieurs (4) adjacents comprennent des zones se chevauchant en séries (6) qui sont remplies du matériau diélectrique accordable (13), chacune formant ainsi un condensateur en séries accordable (14), et en outre la première électrode (2) et la seconde électrode (7) sont espacées dans une seconde direction perpendiculaire à la première direction, moyennant quoi la ligne de transmission (1) comprend des sections parallèles se chevauchant, dans lequel une zone de chevauchement (10) de la première électrode (2) est chevauchée par une zone d'électrode de condensateur (11, 23) et dans lequel une zone de chevauchement (11) de la seconde électrode (7) est chevauchée par une zone d'électrode de condensateur (10, 22), et moyennant quoi le matériau diélectrique accordable (13) est agencé entre les zones d'électrode de condensateur respectives (10, 11, 22, 23) et la zone de chevauchement (10) de la première électrode (2) et la zone de chevauchement (11) de la seconde électrode (7) afin de fournir un condensateur parallèle accordable (15) à l'intérieur de la section de chevauchement parallèle de la ligne de transmission (1) qui affecte la phase du signal électromagnétique de fréquence radio qui se propage le long de la section de chevauchement parallèle de la ligne de transmission (1).

2. Dispositif de décalage de phase de fréquence radio selon la revendication 1, dans lequel la zone de chevauchement (10) de la première électrode (2) chevauche la zone de chevauchement (11) de la seconde électrode (7) pour fournir le condensateur parallèle accordable (15) à l'intérieur de la section de chevauchement parallèle de la ligne de transmission (1).

3. Dispositif de décalage de phase de fréquence radio selon la revendication 1, dans lequel la première électrode (2) et la seconde électrode (7) sont agencées côte à côte dans la seconde direction et dans lequel les segments supérieurs (4) et segments inférieurs (3) respectifs de la première électrode (2) et de la seconde électrode (7) à l'intérieur d'une section de chevauchement parallèle sont agencés au même niveau dans la première direction, et dans lequel une électrode de condensateur (21) est agencée dans la première direction au-dessus ou au-dessous des segments supérieurs (4) ou segments inférieurs (3) correspondants de la première électrode (2) et de la seconde électrode (7) de sorte qu'une première zone d'électrode de condensateur (22) chevauche la zone de chevauchement (10) de la première électrode (2) et qu'une seconde zone d'électrode de condensateur (23) chevauche la zone de chevauchement (11) de la seconde électrode (7), fournissant ainsi deux zones de condensateur à plaques parallèles entre l'électrode de condensateur (21) et les zones de chevauchement respectives (10, 11) à l'intérieur de la section de chevauchement parallèle.

4. Dispositif de décalage de phase de fréquence radio selon l'une ou plusieurs des revendications précédentes, **caractérisé en ce que** tous les segments supérieurs (4) de la première électrode (2) et de la seconde électrode (7) sont agencés à un niveau supérieur et **en ce que** tous les segments inférieurs (3) de la première électrode (2) et de la seconde électrode (7) sont agencés à un niveau inférieur qui est espacé du niveau supérieur le long de la première direction.

5. Dispositif de décalage de phase de fréquence radio selon les revendications 2 et 4, **caractérisé en ce qu'**à l'intérieur d'une section de chevauchement parallèle le long de la ligne de transmission (1) soit un segment supérieur (4) de la première électrode (2) est appairé avec un segment inférieur (3) de la seconde électrode (7), soit un segment inférieur (3) de la première électrode (2) est appairé avec un segment supérieur (4) de la seconde électrode (7).

6. Dispositif de décalage de phase de fréquence radio selon les revendications 3 et 4, **caractérisé en ce qu'**à l'intérieur d'une section de chevauchement parallèle le long de la ligne de transmission (1) soit des segments supérieurs (4) de la première électrode (2) et de la seconde électrode (7) sont appairés, soit des segments inférieurs (3) de la première électrode (2) et de la seconde électrode (7) sont appairés.

7. Dispositif de décalage de phase de fréquence radio selon la revendication 4, **caractérisé en ce qu'**il comprend en outre une première couche de substrat (18) et une seconde couche de substrat (19), dans lequel tous les segments supérieurs (4) de la première électrode (2) et de la seconde électrode (7) sont agencés au niveau d'une première surface de la première couche de substrat (18), et **en ce que** tous les segments inférieurs (3) de la première électrode (2) et de la seconde électrode (7) sont agencés au niveau d'une seconde surface de la seconde couche de substrat (19), moyennant quoi la première surface de la première couche de substrat (18) fait face à la seconde surface de la seconde couche de substrat (19).

8. Dispositif de décalage de phase de fréquence radio selon la revendication 7, caractérisé en ce la première surface de la première couche de substrat (18) et la seconde surface de la seconde couche de substrat (19) confinent le matériau diélectrique accordable (13).

9. Dispositif de décalage de phase de fréquence radio selon une ou plusieurs des revendications précédentes, **caractérisé en ce qu'**il comprend en outre des première et seconde électrodes de polarisation (16, 17) d'au moins une source de tension de polarisation, dans lequel les segments supérieurs (4) et les segments inférieurs (3) de la première électrode (2) et de la seconde électrode (7) sont électriquement connectés aux première et seconde électrodes de polarisation (16, 17).

10. Dispositif de décalage de phase de fréquence radio selon la revendication 9, **caractérisé en ce que** la largeur des première et seconde électrodes de polarisation (16, 17) est inférieure à la largeur des première et seconde électrodes (2, 7) .

11. Dispositif de décalage de phase de fréquence radio selon la revendication 3, **caractérisé en ce que** toutes les électrodes de condensateur (21) chevauchant des segments inférieurs (3) des première et seconde électrodes (2, 7) sont agencées au même niveau de premier condensateur le long de la première direction, moyennant quoi toutes les électrodes de condensateur (21) au niveau du premier condensateur sont connectées avec une première ligne de polarisation d'électrode de condensateur (24), et **en ce que** toutes les électrodes de condensateur (21) chevauchant des segments supérieurs (4) des première et seconde électrodes (2, 7) sont agencées au niveau du même niveau de second condensateur le long de la première direction, moyennant quoi toutes les électrodes de condensateur (21) au niveau du second condensateur sont connectées à une seconde ligne de polarisation d'électrode de condensateur (25).

12. Dispositif de décalage de phase de fréquence radio selon une ou plusieurs des revendications précédentes, **caractérisé en ce que** la première ou seconde électrode (2, 7) ou les deux électrodes (2, 7) sont référencées comme une ou plusieurs électrodes de terre (29, 30) qui sont espacées à une distance de la première ou seconde électrode correspondante (2, 7).

13. Dispositif de décalage de phase de fréquence radio selon une ou plusieurs des revendications précédentes, **caractérisé en ce que** la distance entre des condensateurs séries accordables (14) ou condensateurs parallèles accordables (15) successifs est constante ou variable le long de la ligne de transmission (1).

14. Dispositif de décalage de phase de fréquence radio selon une ou plusieurs des revendications précédentes, **caractérisé en ce que** la taille ou forme des zones de chevauchement (6) des condensateurs séries accordables (14) et la taille ou forme des zones de chevauchement (10, 11) des condensateurs parallèles accordables (15) sont identiques ou variables le long de la ligne de transmission (1).

15. Antenne réseau à éléments en phase comprenant plusieurs éléments d'antenne, un réseau d'alimentation en signaux depuis ou vers lequel un signal est transmis aux ou reçu des plusieurs éléments d'antenne, et pour chaque élément d'antenne un dispositif de décalage de phase correspondant selon la revendication 1, moyennant quoi la phase de chaque signal qui est transmis à partir du réseau d'alimentation en signaux à l'élément d'antenne respectif ou qui est transmis à partir de l'élément d'antenne respectif au réseau d'alimentation en signaux est modifiée afin de régler la superposition de chaque signal en fonction de la direction de rayonnement préférée du système d'antenne.

16. Antenne réseau à éléments en phase selon la revendication 15, **caractérisée en ce que** l'antenne réseau à éléments en phase comprend les unes au sommet des autres une première couche de substrat (18), une couche accordable qui comprend un matériau diélectrique accordable, une seconde couche de substrat (19) et une couche d'antenne dotée d'une structure d'antenne rayonnante pour chacun des éléments de substrat.

17. Antenne réseau à éléments en phase selon la revendication 15 ou 16, **caractérisée en ce que** la première couche de substrat (18) et la seconde couche de substrat (19) consistent en un matériau de verre, et **en ce que** la couche accordable comprend un matériau cristallin liquide (13) présentant des propriétés diélectriques accordables.
